# EUROPEAN PATENT SPECIFICATION

(11) **EP 3 261 136 B1**
(45) Date of publication and mention of the grant of the patent: **02.10.2019**
(21) Application number: 16749301.4
(22) Date of filing: 12.02.2016
(51) Int. Cl.: H01L 33/48, H01L 25/075, H01L 33/62

(54) **LIGHT-EMITTING DEVICE AND METHOD FOR PRODUCING THE SAME**
LICHTEMITTIERENDE VORRICHTUNG UND VERFAHREN ZUR HERSTELLUNG DAVON
DISPOSITIF ÉLECTROLUMINESCENT ET SON PROCÉDÉ DE FABRICATION

(30) Priority: 13.02.2015 JP 2015026895
(43) Date of publication of application: 27.12.2017
(73) Proprietor: Citizen Electronics Co., Ltd., Yamanashi-ken 403-0001 (JP); Citizen Watch Co., Ltd., Tokyo 188-8511 (JP)
(72) Inventor: HIRASAWA, Koki, Fujiyoshida-shi Yamanashi 403-0001 (JP); IINO, Takashi, Fujiyoshida-shi Yamanashi 403-0001 (JP); MATSUMURA, Kazuki, Fujiyoshida-shi Yamanashi 403-0001 (JP)
(74) Representative: Dendorfer, Claus
(86) International application number: PCT/JP2016/054061
(87) International publication number: WO 2016/129658

(56) References cited:
- EP-A2- 2 490 270
- DE-A1- 10 305 021
- JP-A- 2004 119 981
- JP-A- 2010 015 709
- JP-A- 2012 227 179
- JP-A- 2014 049 594
- JP-A- 2014 049 594
- US-A1- 2008 179 619
- US-A1- 2011 215 349
- US-A1- 2013 092 966

## Description

### [Technical Field]

The present invention relates to a light-emitting device including a plurality of light-emitting diodes (LEDs) mounted to a metal substrate, and to a method for producing the light-emitting device.

### [Background Art]

Recently, illumination devices using light-emitting diodes (LEDs) as light sources have become widely used. With the widespread use, there is an increasing need for illumination devices having improved light extraction efficiency and improved ability to be mass-produced and which are less expensive, in addition to having reduced sizes and thicknesses. To reduce the sizes and thicknesses of illumination devices and to increase their light extraction efficiency by improving the heat dissipation properties, the so-called flip-chip mounting is being employed for an increasing number of light-emitting devices. With the flip-chip mounting, LEDs are directly bonded to a lead frame, which is a type of metal substrate.

However, in the case of light-emitting devices for which flip-chip mounting to a lead frame is employed, the lead frame includes a plurality of spaced coupling leads for LEDs, and thus, height differences between the coupling leads, bending, and warping, for example, are problems with flip-chip mounting. As a technique for solving the problems, a technique disclosed in JP 2013-157357 A (see FIG. 2) is known. The technique is to insert an electrically insulating reinforcing plate adjacent to inner ends of the plurality of coupling leads in a lead frame to correct warping.

However, the technique of placing a reinforcing member adjacent to the backside of the lead frame poses problems. The problems include increased cost due to higher number of components, increased production time due to additional steps, and a decreased production yield due to decreased resin flowability in the subsequent resin molding.

One conventional technique for solving the above-described problems of JP 2013-157357 A (see FIG. 2) is the so-called dicing before grinding technique using a metal substrate as proposed in JP 2004-119981 A (see FIG. 3). Hereinafter, the light-emitting device of JP 2004-119981 A (see FIG. 3), which is produced by a dicing before grinding technique, will be described with reference to FIG. 22. FIG. 22 is partially simplified without deviating from the gist of the invention of JP 2004-119981 A (see FIG. 3).

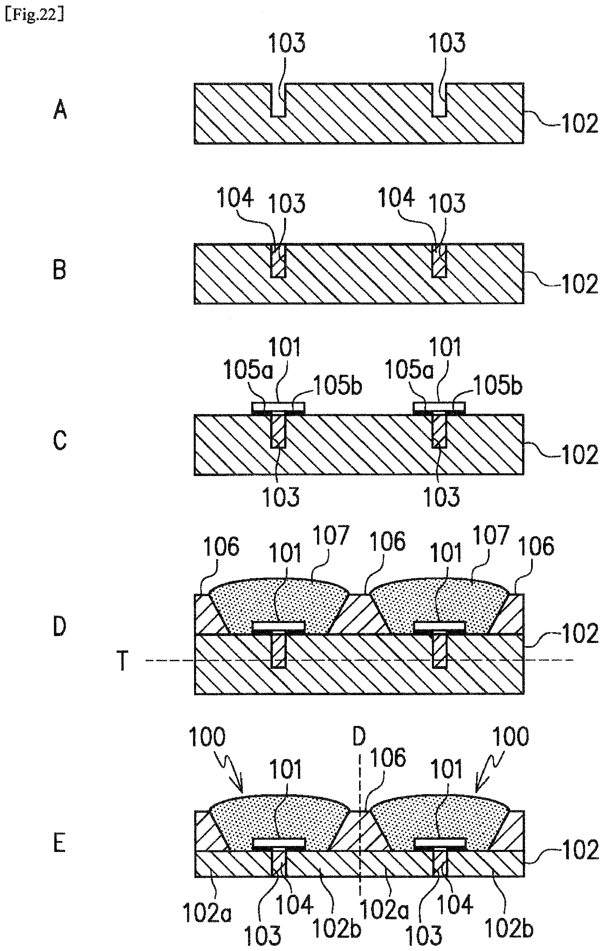

FIGs. 22A to 22E illustrate production steps for a light-emitting device 100 using a dicing before grinding technique. Step A is a groove forming step. In this step, electrode separation grooves 103 are formed in the surface of a metal substrate 102 to a predetermined depth. Step B is a resin pouring step. In this step, an insulative resin 104 is poured into the electrode separation grooves 103.

Step C is an LED mounting step. In this step, LEDs 101 are flip-chip mounted to the surface of the metal substrate 102. Each of the LEDs 101 is positioned at the surface of the metal substrate 102 so as to lie over the electrode separation groove 103, to be coupled to the metal substrate 102 via bumps 105a, 105b.

Step D includes a reflective frame forming step and an encapsulation resin pouring step. In these steps, first, a reflective frame 106 is provided around each of the LEDs 101, which are mounted to the surface of the metal substrate 102, and subsequently, a light-transmissive encapsulation resin 107 is poured inside the reflective frame 106. The light-transmissive encapsulation resin 107 may be a transparent resin or a phosphor-containing transparent resin. Light emitted from the LEDs 101 can be wavelength-converted by the phosphor-containing light-transmissive encapsulation resin 107.

Step E includes a grinding step and a cutting and separation step. In the grinding step, the metal substrate 102 is ground from the backside to the position of the dicing line T, which is indicated by the dashed line in Step D, so as to expose the electrode separation grooves 103 and the insulative resin 104. As a result of exposing the electrode separation grooves 103, the metal substrate 102 is divided into left and right portions with the electrode separation grooves 103 being the boundaries. Thus, pairs of electrode portions 102a, 102b, to which the LEDs 101 are coupled, are formed. In the cutting and separation step, the reflective frame 106 is cut along the cutting line D, indicated by the dashed line, into portions each of which includes an individual LED 101. In this manner, individual light-emitting devices 100 are completed.

JP 2014-049594 A discloses a number of configurations of an optical semiconductor device. The optical semiconductor device comprises a lead frame made of a base material in which an insulating slit is formed. The lead frame comprises a mounting region for mounting an LED element and a reflector formation region surrounding the mounting region. A groove portion is formed to surround the mounting region. A resin reflector is formed in the reflector forming region so that the resin material of the reflector extends into the groove portion.

US 2008/0179619 A1 discloses an edge-emitting light-emitting diode comprising a base, a frame, and at least three chips.

US 103 05 021 A1 discloses a method for surface mounting of high-performance light emitting diodes. A plurality of slots is machined into an electrically and thermally conductive base substrate. The slots do not pass through the thickness of the base substrate. An insulating layer is filled into the slots. The bottom surface of the substrate is machined off until reaching at least the slots and the insulating layer contained therein.

EP 2 490 270 A2 discloses a light-emitting device package that includes a lead frame comprising a plurality of separate leads. A molding member fixes the plurality of leads and comprises an opening portion that exposes the lead frame. A light-emitting chip is attached on the lead frame in the opening portion, wherein a height of the molding member is lower than a height of the light-emitting chip with respect to the lead frame.

### [Disclosure of the Invention]

### [Problems to be Solved by the Invention]

The dicing before grinding technique disclosed in JP 2004-119981 A (see FIG. 3) is a technique for mass-producing single-piece light-emitting devices 100 by the cutting and separation step. In each of the mass-produced light-emitting devices 100, the two electrode portions 102a, 102b of the metal substrate 102 are separated from each other as a result of grinding and are bonded to each other only by the bonding force of the insulative resin 104, which is poured into the electrode separation groove 103. Thus, the bond strength is low, and there is a possibility that the light-emitting devices 100 may become broken while being handled as a light-emitting device. In addition, the reflective frame 106 is merely adhered to the surface of the metal substrate 102 and thus does not increase the bond strength between the electrode portions 102a, 102b.

An object of the present invention is to provide a light-emitting device that is mass-produced using a dicing before grinding technique. The light-emitting device includes electrode portions in a metal substrate, and the bond between the electrode portions, after being separated from one another by grinding, is strong. In particular, for large light-emitting devices in which a plurality of LEDs are coupled together in series to a metal substrate, a strong bond between the electrode portions in the metal substrate is achieved.

### [Means of Solving the Problems]

The invention is defined by the independent claims. The dependent claims concern optional features of some embodiments of the invention.

In order to achieve the above object, a light-emitting device according to one aspect of the present invention includes a metal substrate, insulative portions, a plurality of LEDs, a support frame, and an encapsulation resin. The metal substrate includes electrode portions. The insulative portions are disposed in the metal substrate. The insulative portions each separate corresponding ones of the electrode portions from each other so that one of the electrode portions serves as an anode and an other of the electrode portions serves as a cathode. The insulative portions each include an electrode separation groove in the metal substrate and an insulative resin formed within the electrode separation groove. The plurality of LEDs are positioned at a surface of the metal substrate. Each of the LEDs lies over a corresponding one of the insulative portions and are electrically coupled to corresponding ones of the electrode portions. The support frame is disposed so as to surround an outer perimeter of the metal substrate. The support frame includes an inner wall portion and an outer wall portion. The inner wall portion is formed within a recessed groove along the outer perimeter of the metal substrate. The outer wall portion covers an outer perimeter surface of the metal substrate. The encapsulation resin is formed within the support frame to encapsulate at least partially the LEDs.

Furthermore, in order to achieve the above object, a method according to one aspect of the present invention for producing a light-emitting device is performed as follows. Insulative portions are formed by forming electrode separation grooves of a predetermined depth in a metal substrate and pouring an insulative resin into the electrode separation grooves. The metal substrate includes electrode portions. LED mounting is performed by positioning a plurality of LEDs at a surface of the metal substrate in such a manner that each of the LEDs lies over a corresponding one of the insulative portions and electrically coupling each of the LEDs to an anode of a corresponding one of the electrode portions and to a cathode of a corresponding one of the electrode portions. The electrode portions are separated from one another by the insulative portions. A support frame surrounding an outer perimeter of the metal substrate is formed. The support frame includes an inner wall portion formed within a recessed groove and an outer wall portion covering an outer perimeter surface of the metal substrate. The recessed groove is formed along the outer perimeter of the metal substrate. The metal substrate is ground from a backside of the metal substrate to an extent that the insulative portions are exposed.

### [Effects of the Invention]

In the light-emitting device according to one aspect of the present invention, the inner wall portion of the support frame is formed within the recessed groove in the metal substrate and the outer wall portion of the support frame covers the outer perimeter surface of the metal substrate. This configuration reinforces the bond between the electrode portions in the metal substrate, which are separated from one another by the insulative portions, and as a result, the metal substrate is unified as a whole to form a rigid substrate.

Furthermore, in the method according to one aspect of the present invention for producing a light-emitting device, a support frame is provided so as to surround the outer perimeter of the metal substrate to which LEDs are mounted, and this support frame reinforces the bond between the electrode portions in the metal substrate. This configuration facilitates mass production of large light-emitting devices.

### [Brief Description of the Drawings]

FIG. 1 is a sectional view of a light-emitting device according to a first embodiment of the present invention.
FIG. 2 is a top view of the light-emitting device illustrated in FIG. 1.
FIG. 3 is a bottom view of the light-emitting device illustrated in FIG. 1.
FIGs. 4A to 4D illustrate a process of a method for producing the light-emitting device illustrated in FIG. 1, with the first half of the process being illustrated.
FIGs. 5E to 5G illustrate the process of the method for producing the light-emitting device illustrated in FIG. 1, with the second half of the process being illustrated.
FIG. 6 is a sectional view of a light-emitting device according to a second embodiment of the present invention.
FIG. 7 is a top view of the light-emitting device illustrated in FIG. 6.
FIGs. 8A and 8B illustrate a process of a method for producing the light-emitting device illustrated in FIG. 6.
FIG. 9 is a sectional view of a light-emitting device according to a third embodiment of the present invention.
FIG. 10 is a top view of the light-emitting device illustrated in FIG. 9.
FIGs. 11A to 11D illustrate a process of a method for producing the light-emitting device illustrated in FIG. 9, with the first half of the process being illustrated.
FIGs. 12E to 12G illustrate the process of the method for producing the light-emitting device illustrated in FIG. 9, with the second half of the process being illustrated.
FIG. 13 is a sectional view of a light-emitting device according to a fourth embodiment of the present invention.
FIG. 14 is a top view of the light-emitting device illustrated in FIG. 13.
FIGs. 15A and 15B illustrate a process of a method for producing the light-emitting device illustrated in FIG. 13.
FIG. 16 is a sectional view of a light-emitting device according to a fifth embodiment of the present invention.
FIG. 17 is a top view of the light-emitting device illustrated in FIG. 16.
FIG. 18 is a sectional view of a light-emitting device according to a sixth embodiment of the present invention.
FIG. 19 is a top view of an illumination device including light-emitting devices according to the second embodiment of the present invention.
FIG. 20 illustrates a circuit configuration of the illumination device illustrated in FIG. 19.
FIG. 21 illustrates a circuit configuration of an illumination device including light-emitting devices according to another embodiment of the present invention.
FIGs. 22A to 22E illustrate a process of a method for producing a conventional light-emitting device.

### [Mode for Carrying out the Invention]

Hereinafter, embodiments of the present invention will be described with reference to the drawings. Throughout the embodiments, similar or corresponding elements are assigned the same reference numerals, and redundant descriptions will be omitted.

### {First Embodiment}

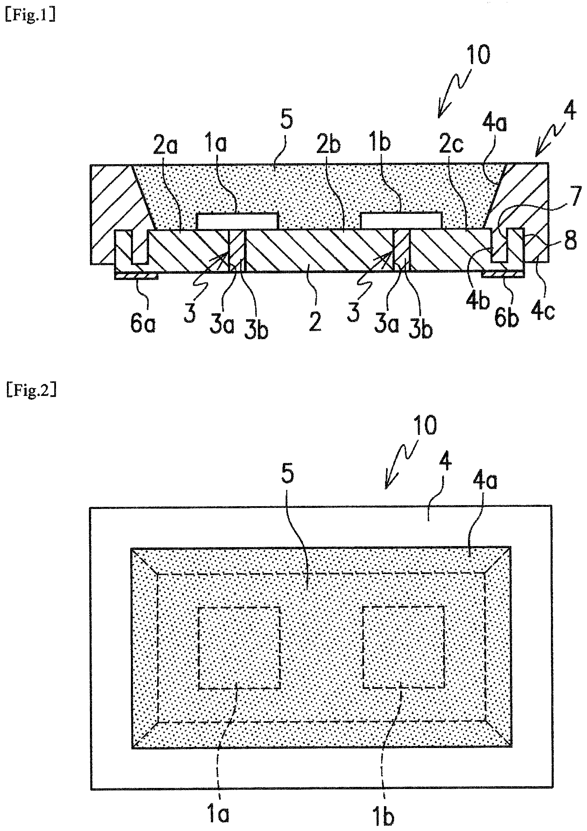

FIGs. 1 to 3 illustrate a light-emitting device according to a first embodiment of the present invention. A light-emitting device 10 according to this embodiment includes a metal substrate 2, a pair of insulative portions 3, three electrode portions 2a, 2b, 2c, two LEDs 1a, 1b, a support frame 4, and a light-transmissive encapsulation resin 5. The metal substrate 2 is rectangular. The insulative portions 3 divide the metal substrate 2 into electrically isolated portions. The electrode portions 2a, 2b, 2c are formed by dividing the metal substrate 2 by the insulative portions 3. The LEDs 1a, 1b are positioned at the surface of the metal substrate 2. Each of the LEDs 1a, 1b lies over a corresponding one of the insulative portions 3 to be electrically coupled to corresponding ones of the electrode portions 2a, 2b, 2c. The support frame 4 is disposed so as to surround the outer perimeter of the metal substrate 2. The light-transmissive encapsulation resin 5 is formed within the support frame 4.

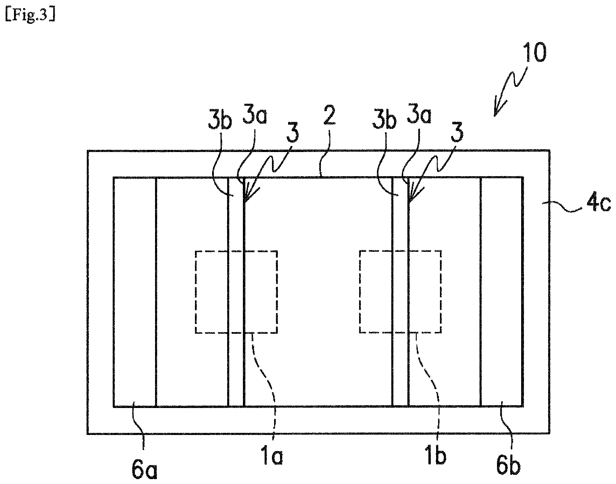

The insulative portions 3 include a pair of electrode separation grooves 3a and an insulative resin 3b. The electrode separation grooves 3a are disposed in the metal substrate 2 and the insulative resin 3b fills the electrode separation grooves 3a. The electrode separation grooves 3a are disposed to extend through the metal substrate 2 to the backside thereof, and as illustrated in FIG. 3, are disposed along the entire width of the metal substrate 2. In the metal substrate 2, the electrical flow is interrupted by the pair of insulative portions 3, and as a result, the three electrode portions 2a, 2b, 2c, separated from one another by the insulative portions 3, are formed in the metal substrate 2.

The two LEDs 1a, 1b are each positioned at the surface of the metal substrate 2 so as to lie over the insulative portion 3 to be electrically coupled to corresponding ones of the three electrode portions 2a, 2b, 2c, which are separated from one another by the insulative portions 3. In this case, as illustrated in FIG. 1, the two LEDs 1a, 1b are mounted in the same polarity direction to corresponding ones of the electrode portions 2a, 2b, 2c, and are coupled together in series to the electrode portions 2a, 2b, 2c. Specifically, for the LED 1a, the electrode portion 2a is one electrode serving as an anode and the electrode portion 2b is the other electrode serving as a cathode, whereas for the LED 1b, the electrode portion 2b is one electrode serving as an anode and the electrode portion 2c is the other electrode serving as a cathode. The LEDs 1a, 1b are coupled to the corresponding ones of the electrode portions 2a, 2b, 2c via bumps (not illustrated). Furthermore, external electrodes 6a, 6b are disposed at the respective ends of the backside of the metal substrate 2. Between the external electrodes 6a, 6b, current flows through the LEDs 1a, 1b via the electrode portions 2a, 2b, 2c.

The support frame 4 includes an inner perimeter surface 4a, which surrounds the outer perimeter of the metal substrate 2 and is inclined toward the bottom. In a lower region of the support frame 4, an inner wall portion 4b and an outer wall portion 4c are disposed along the entire perimeter of the support frame 4. The inner wall portion 4b is formed within a recessed groove 7, which is disposed along the outer perimeter of the metal substrate 2. The outer wall portion 4c covers an outer perimeter surface 8 of the metal substrate 2 in close contact with the outer perimeter surface 8. Desirably, the support frame 4 is made of a highly reflective resin so that the support frame 4 can be highly reflective to the light emitted from the LEDs 1a, 1b. However, by coating at least the inner perimeter surface 4a with a highly reflective coating material, the support frame 4 can be made to be comparably highly reflective.

The light-transmissive encapsulation resin 5 is formed within the support frame 4 and encapsulates the LEDs 1a, 1b. The light-transmissive encapsulation resin 5 is poured to a level near the upper end of the support frame 4 and covers the topsides of the LEDs 1a, 1b. The topsides are light-emitting surfaces. The light-transmissive encapsulation resin 5 is a phosphor-containing transparent resin. For example, by using an yttrium-aluminum-garnet (YAG) phosphor-containing transparent resin as the light-transmissive encapsulation resin, white light-emitting devices can be configured using a blue LED.

In the light-emitting device 10 configured as described above, the inner wall portion 4b of the support frame 4 is formed within the recessed groove 7 in the metal substrate 2 and the outer wall portion 4c of the support frame 4 covers the outer perimeter surface 8 of the metal substrate 2. This configuration reinforces the bond between the three electrode portions 2a, 2b, 2c in the metal substrate 2, which are separated from one another by the insulative portions 3, and as a result, the metal substrate 2 is unified as a whole to form a rigid substrate. The resin for forming the support frame 4 may be the same as or different from the insulative resin 3b for forming the insulative portions 3 in the metal substrate 2. The support frame 4 includes the inner wall portion 4b and the outer wall portion 4c.

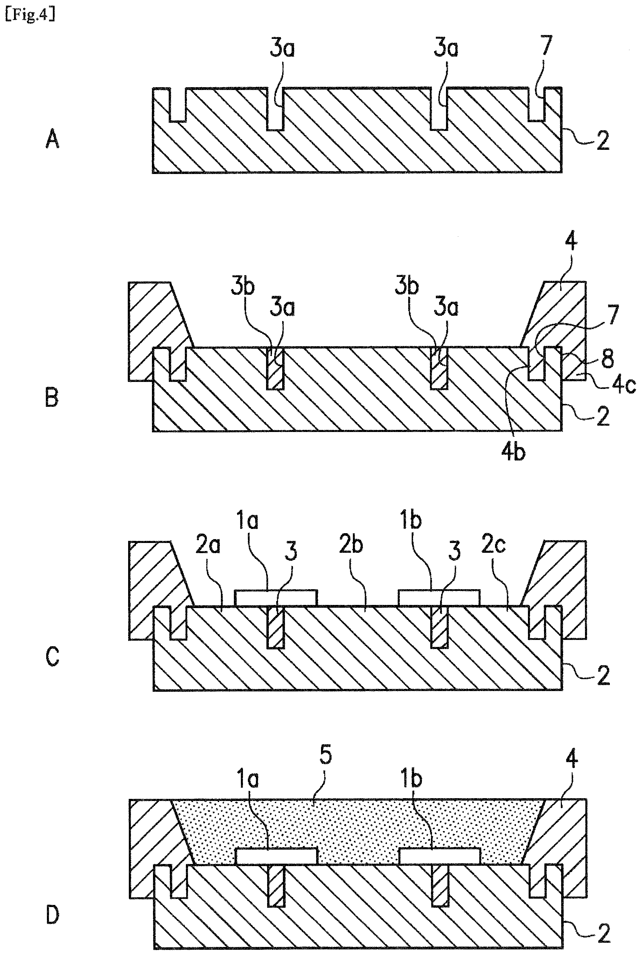

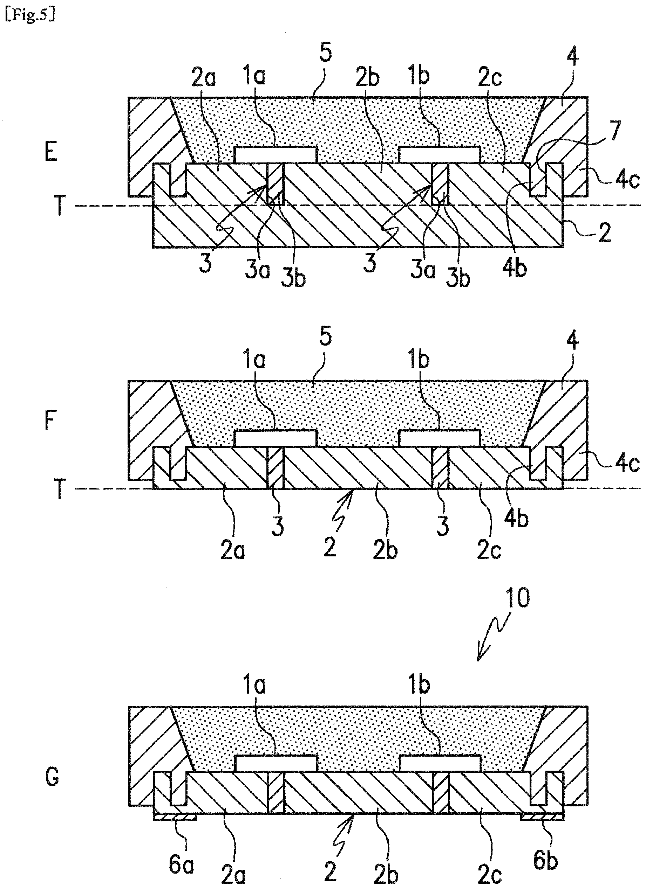

Next, a method for producing the light-emitting device configured as described above will be described with reference to FIGs. 4 and 5. FIGs. 4A to 4D illustrate Steps A to D, the first half of the production process for the light-emitting device 10. Step A in FIG. 4 is a groove forming step. In this step, a pair of electrode separation grooves 3a are formed in the surface of the metal substrate 2 to a predetermined depth. The electrode separation grooves 3a are disposed along the entire width of the metal substrate 2 and are parallel to each another. Further, the recessed groove 7 is formed along the outer perimeter of the metal substrate 2 over the entire perimeter. The recessed groove 7 is formed to be shallower than the electrode separation grooves 3a. The metal substrate 2, prior to the grinding step, has a thickness greater than the thickness of the metal substrate 2 of the light-emitting device 10 illustrated in FIG. 1. The grinding step will be described later.

Step B is a resin pouring step. In this step, the insulative resin 3b is poured into the electrode separation grooves 3a, and a resin is poured into a support frame forming mold (not illustrated), which is placed at the metal substrate 2, to form the support frame 4 to a predetermined shape. The inner wall portion 4b is formed by the resin in the recessed groove 7, and the outer wall portion 4c is formed so as to cover the outer perimeter surface 8 of the metal substrate 2. The outer wall portion 4c is in close contact with the outer perimeter surface 8 of the metal substrate 2. Examples of the insulative resin 3b and the resin for forming the support frame 4 include epoxy resins, silicone resins, and liquid crystal polymers. The insulative resin 3b is to be poured into the electrode separation grooves 3a.

Step C is an LED mounting step. In this step, the LEDs 1a, 1b are positioned at the surface of the metal substrate 2 in such a manner that the LEDs 1a, 1b lie over the respective insulative portions 3. The metal substrate 2 is divided by the insulative portions 3. The two LEDs 1a, 1b are flip-chip mounted via bumps (not illustrated) to the corresponding ones of the three electrode portions 2a, 2b, 2c of the metal substrate 2, which are separated from one another by the insulative portions 3. The two LEDs 1a, 1b are mounted in the same polarity direction to the corresponding ones of the electrode portions 2a, 2b, 2c, and are coupled to each other in series. The LEDs may be mounted by wire bonding depending on the structure.

Step D is an encapsulation resin pouring step. In this step, the light-transmissive encapsulation resin 5 is poured inside the support frame 4 to encapsulate the LEDs 1a, 1b. The light-transmissive encapsulation resin 5 is a phosphor-containing transparent resin. By using a YAG phosphor-containing transparent resin, white light can be produced using a blue LED via wavelength conversion.

FIGs. 5E to 5G illustrate Steps E to G, the second half of the production process for the light-emitting device 10. Steps E and F in FIG. 5 are illustrations of the grinding step. In Step E, a pre-grinding state is illustrated, and in Step F, a post-grinding state is illustrated. In this step, the backside of the metal substrate 2 is ground to a depth at which the electrode portions 2a, 2b, 2c are separated from one another. Specifically, the backside is ground to a grinding line T, which is indicated by the dashed line. Thus, the electrode separation grooves 3a and the insulative resin 3b of the insulative portions 3 are exposed, and as a result, the electrode portions 2a, 2b, 2c are separated from one another. The grinding of the backside of the metal substrate 2 is applied within a region not contacting the bottom of the recessed groove 7 for the support frame 4. The recessed groove 7 is shallower than the electrode separation grooves 3a. Thus, the inner wall portion 4b of the support frame 4 remains present within the recessed groove 7. Also, the backside of the outer wall portion 4c of the support frame 4 is located above the grinding line T. With this configuration, the outer wall portion 4c is protected from damage from the grinding of the backside of the metal substrate 2. Also, in the grinding step, in order to protect, for example, the LEDs 1a, 1b, which are mounted to the surface of the metal substrate 2, the support frame 4, and the light-transmissive encapsulation resin 5 from damage, it is desirable that a grinding protection tape (not illustrated) be laminated to the top surface of the support frame 4, and that the workpiece, with the grinding protection tape on, be set on a grinder.

Step G is an external electrode forming step. In this step, a pair of external electrodes 6a, 6b are provided at the respective ends of the backside of the metal substrate 2 so that electrical current can flow through the LEDs 1a, 1b via the electrode portions 2a, 2b, 2c of the metal substrate 2. With this step, the light-emitting device 10 illustrated in FIG. 1 is completed.

In the production method according to the above embodiment, pouring of the insulative resin 3b into the electrode separation grooves 3a in the metal substrate 2 and forming of the support frame 4 are performed in the same step. As a result, the production process is simplified.

Next, operations of the light-emitting device 10 will be described with reference to FIG. 1. As described above, the LED 1a is mounted to the metal substrate 2 with the electrode portion 2a serving as an anode and the electrode portion 2b serving as a cathode, and the LED 1b is mounted to the metal substrate 2 with the electrode portion 2b serving as an anode and the electrode portion 2c serving as a cathode. Thus, the two LEDs 1a, 1b are coupled together in series to the three electrode portions 2a, 2b, 2c of the metal substrate 2, which are separated from one another by the insulative portions 3. When a driving voltage is applied externally, via the external electrodes 6a, 6b, across the electrode portions 2a, 2c at the respective ends, the two LEDs 1a, 1b are actuated to light up.

### {Second Embodiment}

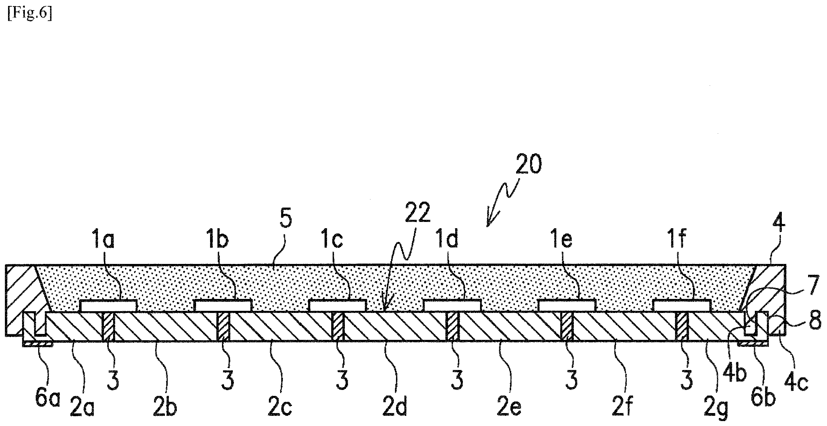

FIGs. 6 to 8 illustrate a light-emitting device according to a second embodiment of the present invention. Compared with the light-emitting device 10 of the first embodiment, in which the two LEDs 1a, 1b are coupled together in series, a light-emitting device 20 according to this embodiment is a large light-emitting device in which six LEDs 1a, 1b, 1c, 1d, 1e, If are coupled together in series. However, except for this feature, the light-emitting device 20 is similar to the light-emitting device 10 in general configuration and production method. Thus, similar or corresponding elements to those of the light-emitting device 10 of the first embodiment are assigned the same reference numerals, and redundant descriptions will be omitted.

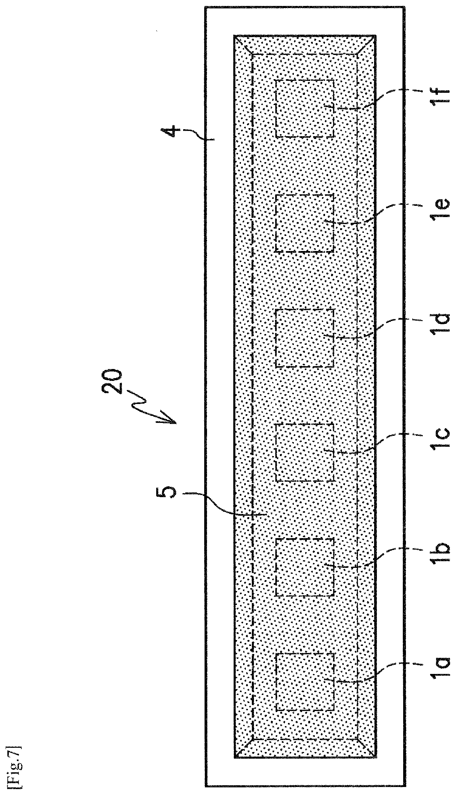

As illustrated in FIGs. 6 and 7, the light-emitting device 20 includes a metal substrate 22, six insulative portions 3, a support frame 4, seven electrode portions 2a, 2b, 2c, 2d, 2e, 2f, 2g, six LEDs 1a to 1f, a light-transmissive encapsulation resin 5, and external electrodes 6a, 6b. The metal substrate 22 is rectangular and large. The insulative portions 3 are spaced along the longitudinal direction of the metal substrate 22 at a predetermined interval. The support frame 4 is provided so as to surround the entire outer perimeter of the metal substrate 22. The electrode portions 2a, 2b, 2c, 2d, 2e, 2f, 2g are portions of the metal substrate 22, which are separated from one another by the six insulative portions 3. The LEDs 1a to 1f are flip-chip mounted by being positioned at the surface of the metal substrate 22 and being electrically coupled to corresponding ones of the electrode portions 2a to 2g. The LEDs 1a to If lie over the respective insulative portions 3. The light-transmissive encapsulation resin 5 is poured inside the support frame 4 to encapsulate the LEDs 1a to 1f. The external electrodes 6a, 6b are disposed at the backside of the metal substrate 22 at the respective ends in the longitudinal direction. As with the first embodiment, the inner wall portion 4b and the outer wall surface 4c are disposed in a lower region of the support frame 4. The inner wall portion 4b is formed within the recessed groove 7, which is disposed along the outer perimeter of the metal substrate 22. The outer wall surface 4c covers the outer perimeter surface 8 of the metal substrate 22.

As with the first embodiment, the six LEDs 1a to If are flip-chip mounted in the same polarity direction to the surface of the metal substrate 22, and are coupled together in series to the electrode portions 2a to 2g, which are separated from one another by the insulative portions 3. The electrode portions 2a, 2g, to which the two outermost LEDs, 1a, 1f, are respectively coupled, are coupled to the external electrodes 6a, 6b, respectively.

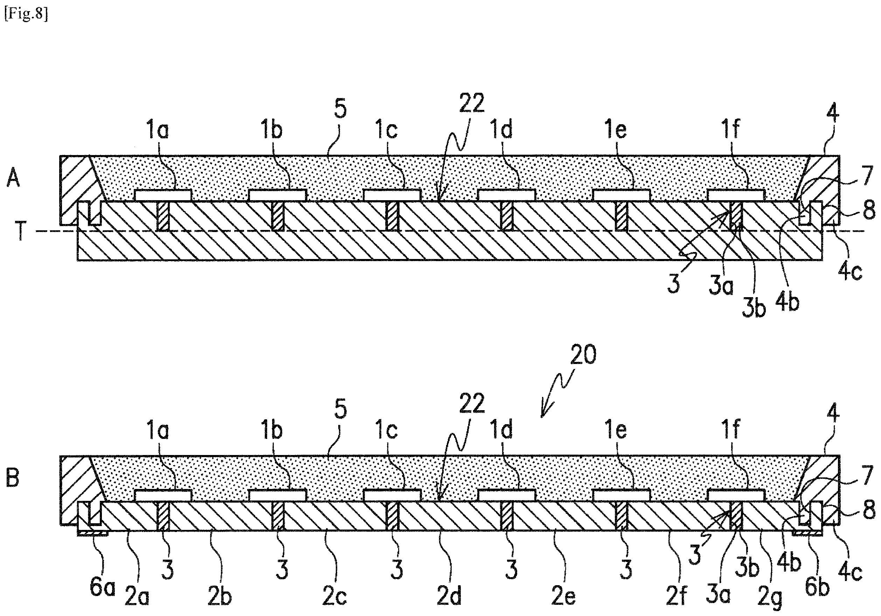

Next, a method for producing the light-emitting device configured as described above will be described with reference to FIG. 8. FIGs. 8A and 8B illustrate production steps for the light-emitting device 20. Step A corresponds to the production steps A to E for the light-emitting device 10 of the first embodiment, and Step B corresponds to the production step G for the light-emitting device 10. The production process in Steps A and B in FIG. 8 is similar to that for the light-emitting device 10 in the first embodiment except for the number of the insulative portions in the metal substrate, the number of the electrode portions separated from one another by the insulative portions, and the number of the LEDs positioned at the metal substrate so as to lie over the respective insulative portions and flip-chip mounted to corresponding ones of the electrode portions. Thus, similar or corresponding elements are assigned the same reference numerals, and redundant descriptions will be omitted.

Next, operations of the light-emitting device 20 will be described with reference to FIG. 6. When a driving voltage is applied externally across the external electrodes 6a, 6b, the series-coupled six LEDs 1a to If are actuated to light up. The external electrodes 6a, 6b are directly coupled respectively to the electrode portions 2a, 2g at the respective ends of the metal substrate 22. That is, the number of series-coupled LEDs is increased, and as a result, the light-emitting device 20 has a high luminance.

### {Third Embodiment}

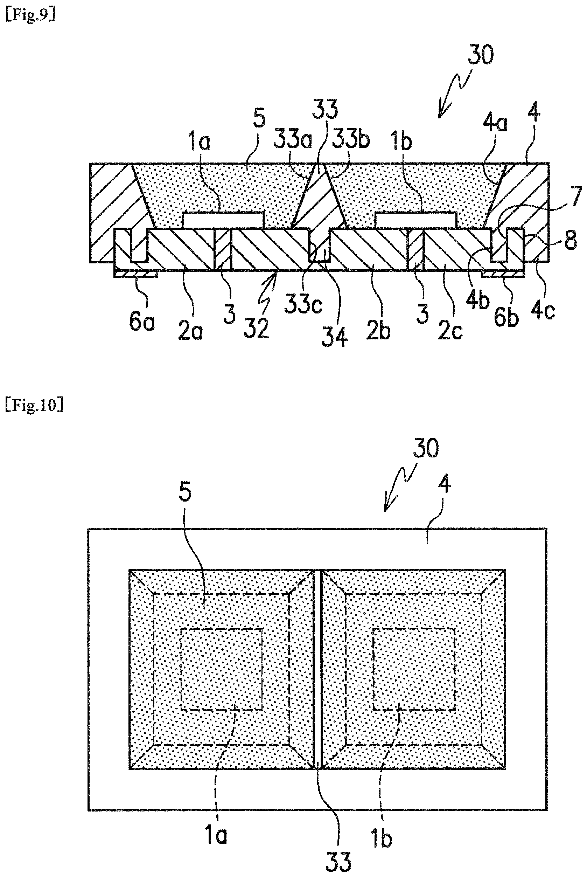

FIGs. 9 to 12 illustrate a light-emitting device according to a third embodiment of the present invention. A light-emitting device 30 according to this embodiment is different from the above-described light-emitting device of the first embodiment in that the light-emitting device 30 includes a shield wall 33 between the two LEDs 1a, 1b, which are mounted to the metal substrate 32. Except for this feature, the light-emitting device 30 is similar to the light- emitting device of the first embodiment in general configuration and production method. Thus, similar or corresponding elements to those of the light-emitting device 10 of the first embodiment are assigned the same reference numerals, and redundant descriptions will be omitted.

As illustrated in FIGs. 9 and 10, the light-emitting device 30 includes the shield wall 33. The shield wall 33 is located at an approximately middle position between the pair of insulative portions 3, which are disposed in the metal substrate 32. The shield wall 33 is approximately parallel to the insulative portions 3. The shield wall 33 is, in cross section, trapezoidal and symmetrical with respect to the vertical axis. The shield wall 33 includes reflective surfaces 33a, 33b on the respective opposite sides. The reflective surfaces 33a, 33b are inclined at an inclination angle approximately equal to the inclination angle of the inner perimeter surface 4a of the support frame 4. The height of the shield wall 33 is approximately equal to the height of the support frame 4. The light-transmissive encapsulation resin 5 fills the space up to the height of the top surface of the shield wall 33. A leg portion 33c is disposed in a lower region of the shield wall 33 and extends downwardly. The leg portion 33c is formed within a recessed groove 34, which is disposed in the surface of the metal substrate 32. The depth of the recessed groove 34 is approximately equal to the depth of the recessed groove 7 in the metal substrate 32. Within the recessed groove 7, the inner wall portion 4b of the support frame 4 is formed. Thus, the metal substrate 32 is continuous under the leg portion 33c. Thus, the three electrode portions 2a, 2b, 2c, which are separated from one another by the insulative portions 3, are formed in the metal substrate 32.

The shield wall 33 serves as a shield for preventing light emitted from the two LEDs 1a, 1b, mounted to the metal substrate 32, from affecting each other. The shield wall 33 also serves as a reflector for reflecting light emitted from the LEDs 1a, 1b and causing the light to propagate upwardly. Thus, it is desirable to use a highly reflective resin as a shield wall-forming resin for forming the shield wall 33 or to apply a highly reflective coating material to the reflective surfaces 33a, 33b of the shield wall 33. Furthermore, in this embodiment, the reflective surfaces 33a, 33b of the shield wall 33 are linearly inclined to reflect light emitted from the LEDs 1a, 1b. Alternatively, the reflective surfaces 33a, 33b may be curvedly inclined to produce a similar reflection effect. In this embodiment, the shield wall 33 is provided between the two LEDs 1a, 1b, so that light emitted from the side surfaces of the LEDs 1a, 1b can be reflected. Because of this configuration, the light-emitting device 30 has improved light emission intensity compared with the light-emitting device 10 of the first embodiment.

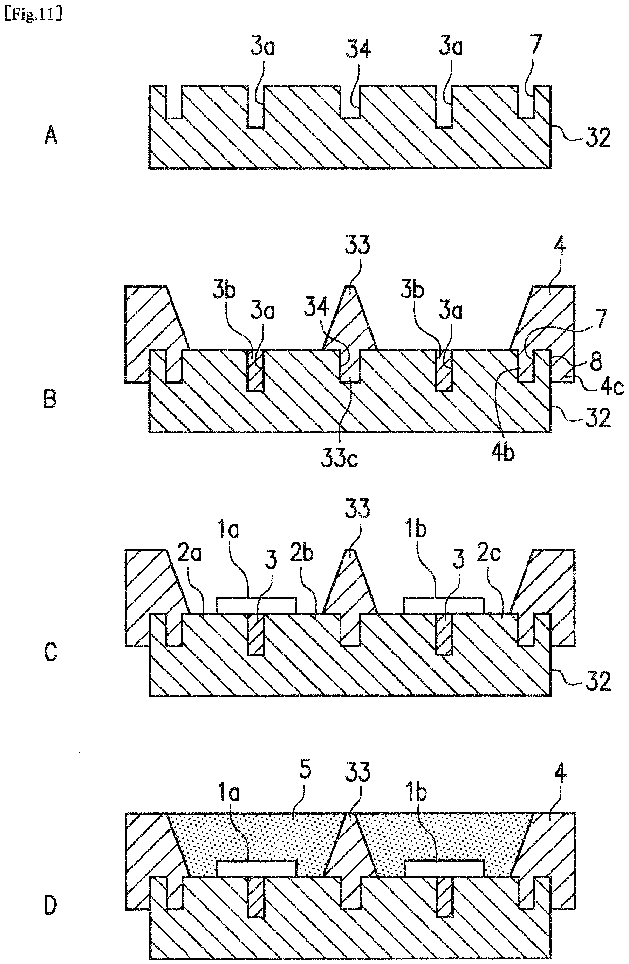

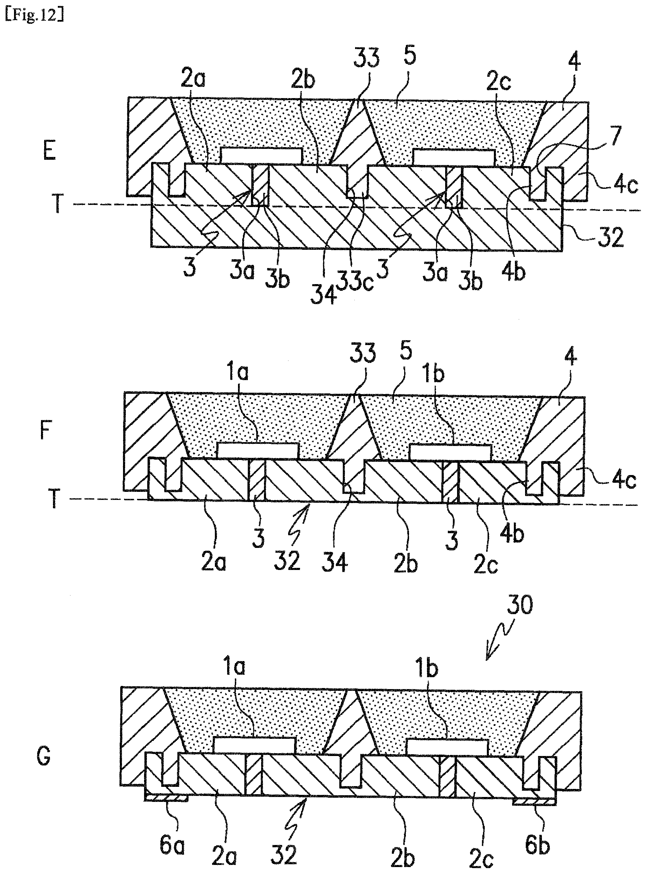

Next, a method for producing the light-emitting device 30 configured as described above will be described with reference to FIGs. 11 and 12. FIGs. 11A to 11D illustrate Steps A to D, the first half of the production process for the light-emitting device 30. FIGs. 12E to 12G illustrate Steps E to G, the second half of the production process for the light-emitting device 30. Step A in FIG. 11 is a groove forming step. In this step, as with the first embodiment, the pair of electrode separation grooves 3a are formed in the surface of the metal substrate 32 with a predetermined distance in between and the recessed groove 7 is formed along the outer perimeter of the metal substrate 32. In addition, the recessed groove 34 is formed in an approximately middle position between the pair of electrode separation grooves 3a. The recessed groove 34 is parallel to the electrode separation grooves 3a and disposed along the entire width of the metal substrate 32. The recessed groove 7 and the recessed groove 34 have an approximately equal depth and are shallower than the electrode separation grooves 3a.

Step B is a resin pouring step. In this step, as with the first embodiment, the insulative resin 3b is poured into the electrode separation grooves 3a, and a resin is poured inside the mold frame of a support frame forming mold to form the support frame 4 to a predetermined shape. The support frame forming mold is placed at the metal substrate 32. Simultaneously with the placement of the support frame forming mold, a mold for forming the shield wall 33 is placed to form the shield wall 33. In the process, the resin in the recessed groove 34 forms the leg portion 33c of the shield wall 33. Examples of the insulative resin 3b, the resin for forming the support frame 4, and the resin for forming the shield wall 33 include epoxy resins, silicone resins, and liquid crystal polymers. The insulative resin 3b is to be poured into the electrode separation grooves 3a.

Step C is an LED mounting step. In this step, the two LEDs 1a, 1b are positioned at the surface of the metal substrate 32, which is partitioned into left and right sections by the shield wall 33, in such a manner that the LEDs 1a, 1b lie over the respective insulative portions 3. The two LEDs are flip-chip mounted via bumps (not illustrated) to the corresponding ones of the three electrode portions 2a, 2b, 2c of the metal substrate 32, which are separated from one another by the insulative portions 3. The two LEDs 1a, 1b are mounted in the same polarity direction to the corresponding ones of the electrode portions 2a, 2b, 2c, and are coupled to each other in series.

Step D is an encapsulation resin pouring step. In this step, the light-transmissive encapsulation resin 5 is poured inside the support frame 4 to encapsulate the LEDs 1a, 1b. The light-transmissive encapsulation resin 5 is supplied to the height of the top surfaces of the support frame 4 and the shield wall 33. By using a YAG phosphor-containing transparent resin as the light-transmissive encapsulation resin 5, white light can be produced by wavelength-converting the light emitted from a blue LED.

FIGs. 12E and 12F are illustrations of a grinding step for the metal substrate 32. In Step E, a pre-grinding state is illustrated, and in Step F, a post-grinding state is illustrated. In this grinding step, the backside of the metal substrate 32 is ground to a depth at which the electrode portions 2a, 2b, 2c are separated from one another. Specifically, the backside is ground to a grinding line T, which is indicated by the dashed line. Thus, the electrode separation grooves 3a and the insulative resin 3b of the insulative portions 3 are exposed, and as a result, the electrode portions 2a, 2b, 2c are separated from one another. The grinding of the backside is applied within a region not contacting the bottoms of the recessed groove 7 for the support frame 4 and the recessed groove 34 for the shield wall 33. The recessed groove 7 and the recessed groove 34 are shallower than the electrode separation grooves 3a. Thus, the inner wall portion 4b of the support frame 4 remains present within the recessed groove 7, and the leg portion 33c of the shield wall 33 remains present within the recessed groove 34. As a result, the portion of the metal substrate 32 under the leg portion 33c remains present, and thus the LED 1a and the LED 1b are electrically coupled to each other with the electrode portion 2b remaining undivided. Also, as with the first embodiment, the backside of the outer wall portion 4c of the support frame 4 is located above the grinding line T. With this configuration, the outer wall portion 4c is protected from damage from the grinding of the backside of the metal substrate 32. Also, in the grinding step, in order to protect, for example, the LEDs 1a, 1b, which are mounted to the surface of the metal substrate 32, the support frame 4, the shield wall 33, and the light-transmissive encapsulation resin 5 from damage, it is desirable that a grinding protection tape (not illustrated) be laminated to the top surfaces of the support frame 4 and the shield wall 33, and that the workpiece, with the grinding protection tape on, be set on a grinder.

Step G is an external electrode forming step. In this step, a pair of external electrodes 6a, 6b are provided at the respective ends of the backside of the metal substrate 32 so that electrical current can flow through the LEDs 1a, 1b via the electrode portions 2a, 2b, 2c of the metal substrate 32. With this step, the light-emitting device 30 illustrated in FIG. 9 is completed.

In the production method according to the above embodiment, pouring of the insulative resin 3b into the electrode separation grooves 3a in the metal substrate 32, forming of the support frame 4, and forming of the shield wall 33 are performed in the same step. As a result, the production process is simplified.

In the light-emitting device 30, which is produced by the production process described above, the backside of the metal substrate 32 is ground in the grinding step to an extent that the insulative portions 3 are exposed, but the inner wall portion 4b and the outer wall portion 4c of the support frame 4 surrounds the outer perimeter of the metal substrate 32 for reinforcement. As a result, the metal substrate 32 is unified as a whole to form a rigid substrate.

Next, operations of the light-emitting device 30 will be described with reference to FIG. 9. In this embodiment, the two LEDs 1a, 1b are shielded from each other by the shield wall 33, but the metal substrate 32 is continuous under the shield wall 33 as described above. Thus, as with the first embodiment, the LED 1a is mounted to the metal substrate 32 with the electrode portion 2a serving as an anode and the electrode portion 2b serving as a cathode, and the LED 1b is mounted to the metal substrate 32 with the electrode portion 2b serving as an anode and the electrode portion 2c serving as a cathode. Thus, the two LEDs 1a, 1b are coupled together in series to the three electrode portions 2a, 2b, 2c of the metal substrate 32, which are separated from one another by the insulative portions 3. When a driving voltage is applied externally, via the external electrodes 6a, 6b, across the electrode portions 2a, 2c at the respective ends, the two LEDs 1a, 1b are actuated to light up.

### {Fourth Embodiment}

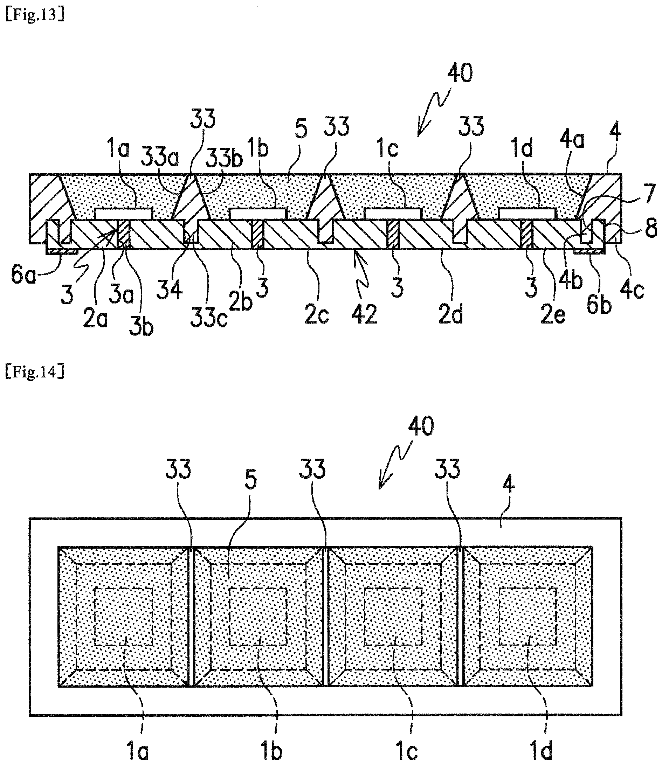

FIGs. 13 to 15 illustrate a light-emitting device according to a fourth embodiment of the present invention. Compared with the light-emitting device 30 of the third embodiment, in which the two LEDs 1a, 1b are coupled together in series, a light-emitting device 40 according to this embodiment is a large light-emitting device in which four LEDs 1a, 1b, 1c, 1d are coupled together in series. However, except for this feature, the light-emitting device 40 is similar to the light-emitting device 30 in general configuration and production method. Thus, similar or corresponding elements to those of the light-emitting device 30 of the third embodiment are assigned the same reference numerals, and redundant descriptions will be omitted.

As illustrated in FIGs. 13 and 14, the light-emitting device 40 includes a metal substrate 42, four insulative portions 3, a support frame 4, five electrode portions 2a, 2b, 2c, 2d, 2e, four LEDs 1a, 1b, 1c, 1d, three shield walls 33, a light-transmissive encapsulation resin 5, and external electrodes 6a, 6b. The metal substrate 42 is rectangular and large. The insulative portions 3 are spaced along the longitudinal direction of the metal substrate 42 at a predetermined interval. The support frame 4 is formed so as to surround the entire outer perimeter of the metal substrate 42. The electrode portions 2a, 2b, 2c, 2d, 2e are separated from one another by the four insulative portions 3. The LEDs 1a, 1b, 1c, 1d are flip-chip mounted to the surface of the metal substrate 42 to be electrically coupled to corresponding ones of the electrode portions 2a to 2e. The LEDs 1a, 1b, 1c, 1d lie over the respective insulative portions 3. The shield walls 33 are disposed on the surface of the metal substrate 42 to shield the four LEDs 1a to 1d, each from adjacent one(s) of the four LEDs. The light-transmissive encapsulation resin 5 is disposed inside the support frame 4 to encapsulate the LEDs 1a to 1d. The external electrodes 6a, 6b are disposed at the backside of the metal substrate 42 at the respective ends in the longitudinal direction.

As with the third embodiment, the four LEDs 1a to 1d are flip-chip mounted in the same polarity direction to the surface of the metal substrate 42, and are coupled together in series to the electrode portions 2a to 2e of the metal substrate 42, which are separated from one another by the insulative portions 3. The electrode portions 2a, 2e, to which the two outermost LEDs, 1a, 1d, are respectively coupled, are coupled to the external electrodes 6a, 6b, respectively.

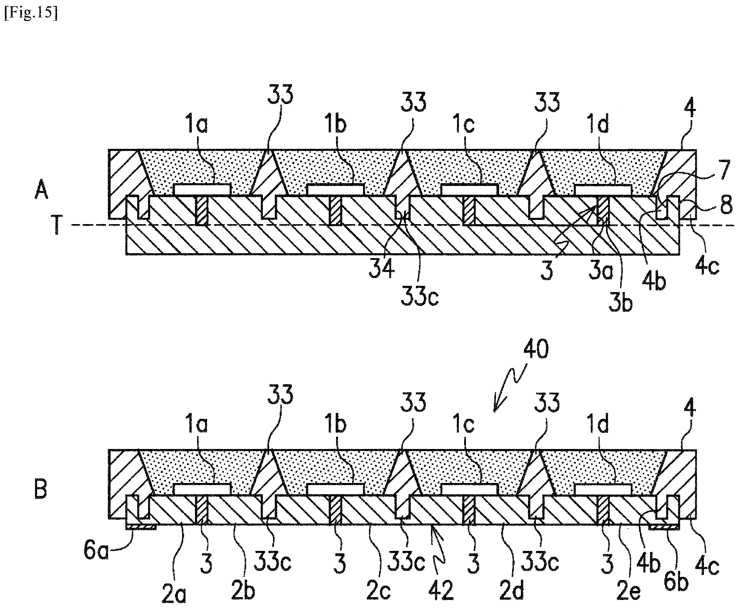

FIGs. 15A and 15B illustrate a production process for the light-emitting device 40 according to the fourth embodiment. Steps A and B correspond to the steps for the light-emitting device 30 of the third embodiment. Step A corresponds to the steps from the groove forming step through the grinding step, which are illustrated in FIGs. 11 and 12. Step B corresponds to the external electrode forming step illustrated therein. The production process in FIG. 15, including Steps A and B, is similar to the production process for the light-emitting device 30 of the third embodiment except for the number of the insulative portions 3 in the metal substrate 42, the number of the electrode portions 2a to 2e of the metal member 42, which are separated from one another by the insulative portions 3, the number of the LEDs 1a to 1d, positioned at the surface of the metal substrate 42 so as to lie over the respective insulative portions 3 and flip-chip mounted to corresponding ones of the electrode portions 2a to 2e, and the number of the shield walls 33, which shield the LEDs, each from adjacent one(s) of the LEDs. Thus, similar or corresponding elements are assigned the same reference numerals, and redundant descriptions will be omitted.

Operations of the LED light-emitting device 40 will be described with reference to FIG. 13. When a driving voltage is applied across the electrode portions 2a, 2e at the respective ends via the external electrodes 6a, 6b, the four series-coupled LEDs 1a to 1d are actuated to light up. Light emitted from the LEDs 1a to 1d can be reflected by the inner perimeter surface 4a of the support frame 4, which surrounds the LEDs 1a to 1d, and by the reflective surfaces 33a, 33b of the shield walls 33, and therefore light propagating upward will increase in intensity. Thus, the light-emitting device 40 has a high luminance.

### {Fifth Embodiment}

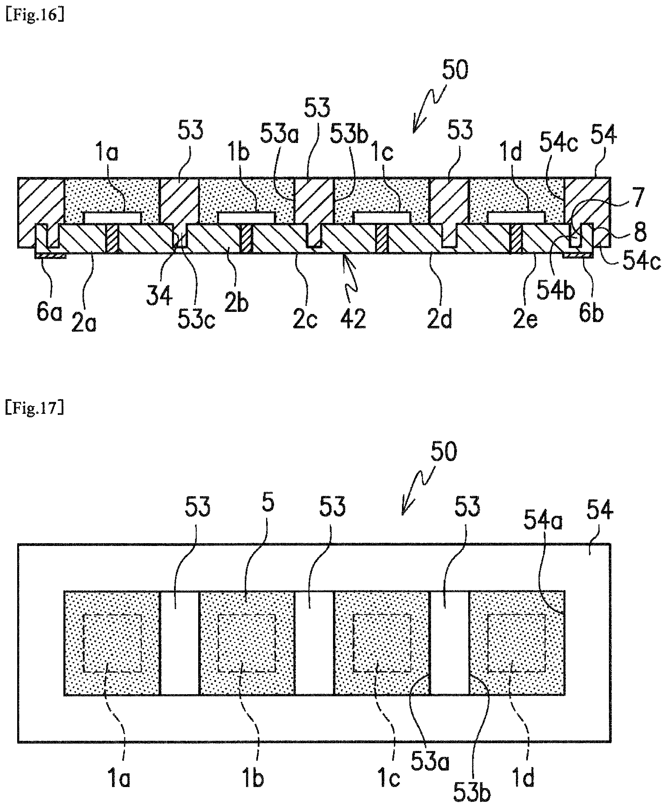

FIGs. 16 and 17 illustrate a light-emitting device according to a fifth embodiment of the present invention. The light-emitting device 50 of this embodiment includes a support frame 54 and shield walls 53, which are different in shape from those of the light-emitting device 40 of the fourth embodiment. The support frame 54 surrounds the outer perimeter of the metal substrate 42, and the shield walls 53 shield the four LEDs 1a to 1d, each from adjacent one(s) of the four LEDs. That is, in the fourth embodiment, the inner perimeter surface 4a of the support frame 4 and the reflective surfaces 33a, 33b of the shield walls 33 are both inclined surfaces, whereas, in this embodiment, an inner perimeter surface 54a of the support frame 54 and reflective surfaces 53a, 53b of the shield walls 53 on the respective opposite sides are vertical surfaces. As a result, the light emitted from the LEDs 1a to 1d will not diffuse upward but will propagate directly upward, and thus the emitted light can easily reach remote locations. As a result, the light-emitting device is suitable as, for example, a light-emitting device such as a camera flashlight. An inner wall portion 54b and an outer wall portion 54c are disposed in a lower region of the support frame 54. The inner wall portion 54b is formed within the recessed groove 7, which is formed along the outer perimeter of the metal substrate 42. The outer wall portion 54c covers the outer perimeter surface 8 of the metal substrate 42. A leg portion 53c is disposed in a lower region of the shield wall 53. The leg portion 53c is formed within a recessed groove 34, which is disposed in the metal substrate 42. Except for this feature, this embodiment is similar to the fourth embodiment in general configuration and production method. Thus, similar or corresponding elements to those of the light-emitting device 40 of the fourth embodiment are assigned the same reference numerals, and redundant descriptions will be omitted.

### {Sixth Embodiment}

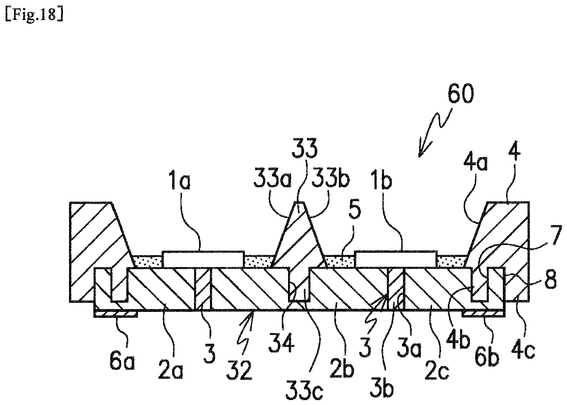

FIG. 18 illustrates a light-emitting device according to a sixth embodiment of the present invention. In the light-emitting device 60 according to this embodiment, the light-transmissive encapsulation resin 5, which is formed within the support frame 4, does not encapsulate the entireties of the LEDs 1a, 1b but encapsulates only the lateral sides and bottomsides of the LEDs 1a, 1b so as to expose the topsides. The topsides are light-emitting surfaces of the LEDs 1a, 1b. Except for this feature, the light-emitting device 60 is similar in general configuration to the light-emitting device 30 of the third embodiment. The light-emitting device 30 is illustrated in FIG. 9. Thus, similar or corresponding elements to those of the light-emitting device 30 are assigned the same reference numerals, and redundant descriptions will be omitted.

With the light-emitting device 60 according to this embodiment, light emitted from the topsides of the LEDs 1a, 1b is not wavelength-converted by a phosphor, and therefore the light-emitting device 60 is suitable for use as a single-color light-emitting device. Furthermore, because of the absence of a phosphor over the topsides of the LEDs 1a, 1b, there is no conversion loss that may otherwise occur from wavelength conversion, and this results in the effect of increasing the light output.

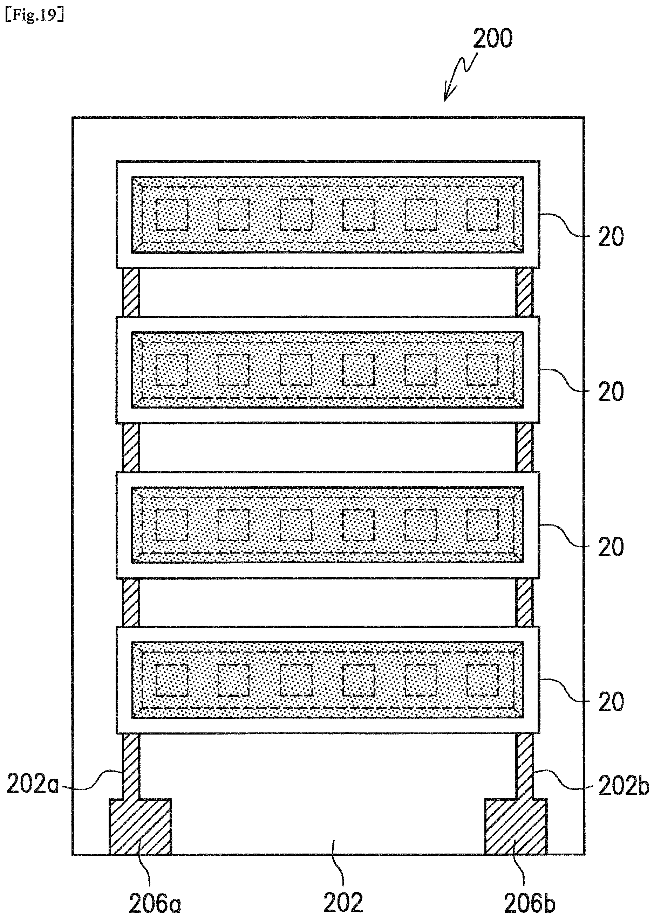

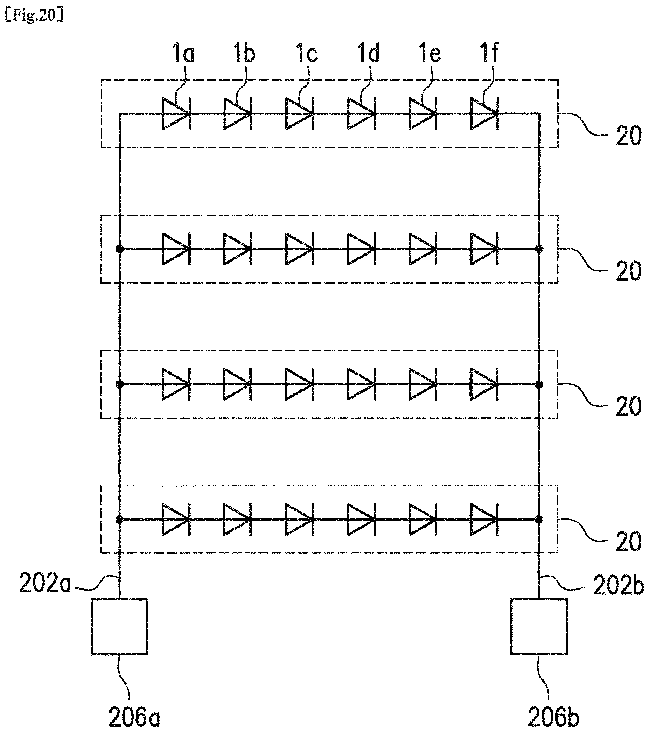

FIGs. 19 and 20 illustrate an illumination device including a plurality of the light-emitting devices 20 according to the second embodiment. The light-emitting device 20 is illustrated in FIG. 6.

The illumination device 200 illustrated in FIG. 19 includes a circuit board 202, two electrode traces 202a, 202b, and four light-emitting devices 20. The electrode traces 202a, 202b are disposed on the circuit board 202 to extend parallel to each other. The light-emitting devices 20 are arranged on the electrode traces 202a, 202b. The four light-emitting devices 20 are coupled together in parallel to the electrode traces 202a, 202b. At one ends of the two electrode traces 202a 202b, external coupling electrodes 206a, 206b are respectively disposed. When a driving voltage is applied across the external coupling electrodes 206a, 206b, the four light-emitting devices 20 light up. Thus, the illumination device 200 has a luminance corresponding to combined luminances of the four light-emitting devices.

FIG. 20 illustrates a circuit configuration of the illumination device 200. The four light-emitting devices 20 are coupled together in parallel to the two electrode traces 202a, 202b, which are respectively coupled to the two external coupling electrodes 206a, 206b. That is, in this illumination device 200, the four light-emitting devices 20 are coupled together in parallel between the external coupling electrodes 206a, 206b. In each of the light-emitting devices 20, the six LEDs 1a to 1f, in the same polarity direction, are coupled together in series. When a driving voltage is applied across the external coupling electrodes 206a, 206b, the 24 LEDs, which constitute the four light-emitting devices 20, light up. Thus, high luminance illumination is achieved

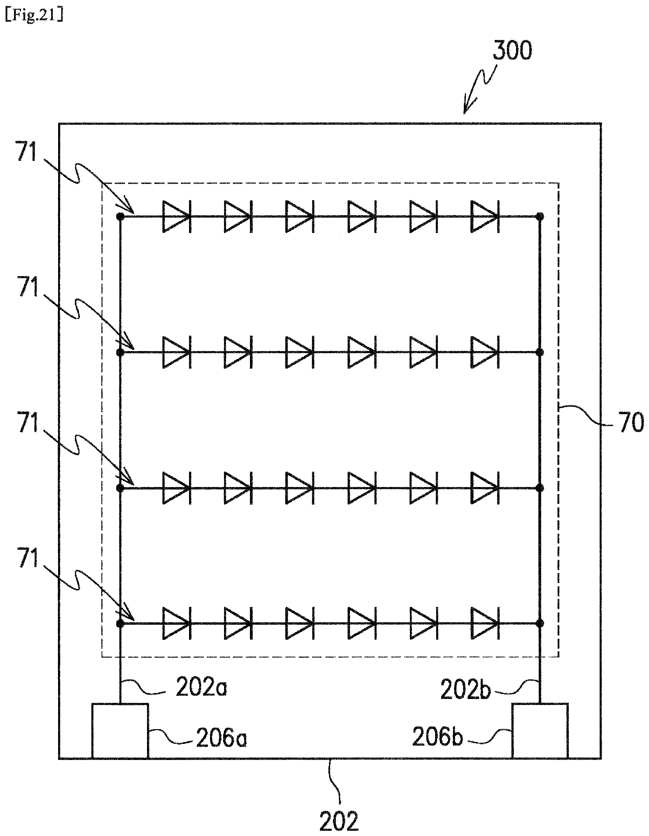

The illumination device 200 can be made simply by mounting a plurality of the light-emitting devices 20 of the present invention on the circuit board 202. The circuit board 202 has a simple electrode structure, which includes the two electrode traces 202a, 202b and the external coupling electrodes 206a, 206b. In addition, by varying the number of the light-emitting devices 20 to be mounted, illumination devices of various luminances can be made. The light-emitting devices to be mounted to the circuit board 202 are not limited to the light-emitting devices 20 of the second embodiment, and any of the light-emitting devices of the other embodiments described above may be employed. Furthermore, as illustrated in FIG. 21, a light-emitting device 70 may be formed using a single large metal substrate. The light-emitting device 70 includes four light-emitting strings 71, arranged side by side, and in each of the light-emitting strings 71, six LEDs are coupled together in series. The light-emitting device 70 may be mounted to the circuit board 202 described above to form an illumination device 300, which is similar to the above-described illumination device. The four light-emitting strings 71, arranged side by side, are each insulated from adjacent one(s) of the four light-emitting strings 71.

As described above, light-emitting devices according to the present invention are applicable to any of a variety of illumination devices, and are suitable as a light source for general illumination purposes, a light source for a liquid crystal display backlight, and a light source for a camera flashlight, for example.

### [Description of the Reference Numerals]

- 1a to 1f: LED
- 2, 22, 32, 42: metal substrate
- 2a to 2g: electrode portion
- 3: insulative portion
- 3a: electrode separation groove
- 3b: insulative resin
- 4, 54: support frame
- 4a, 54a: inner perimeter surface
- 4b, 54b: inner wall portion
- 4c, 54c: outer wall portion
- 5: light-transmissive encapsulation resin
- 6a, 6b: external electrode
- 7: recessed groove
- 8: outer perimeter surface
- 10, 20, 30, 40, 50, 60, 70: light-emitting device
- 33, 53: shield wall
- 33a, 33b, 53a, 53b: reflective surface
- 33c, 53c: leg portion
- 34: recessed groove
- 71: light-emitting string
- 200, 300: illumination device
- 202: circuit board
- 202a, 202b: electrode trace
- 206a, 206b: external coupling electrode

## Claims

1. A light-emitting device (10, 20, 30, 40, 50, 60) comprising:
a metal substrate (2, 22, 32, 42) comprising electrode portions (2a-2g) in a topside of the metal substrate (2, 22, 32, 42);
a first recessed groove (7) along a perimeter of the topside of the metal substrate (2, 22, 32, 42);
insulative portions (3) each separating corresponding ones of the electrode portions (2a - 2g) from each other so that one of the electrode portions (2a-2g) serves as an anode and another of the electrode portions (2a-2g) serves as a cathode, the insulative portions (3) each comprising an electrode separation groove (3a) extending through the metal substrate (2, 22, 32, 42) and an insulative resin (3b) filling the electrode separation groove (3a) and exposed to a backside of the metal substrate (2, 22, 32, 42);
a plurality of LEDs (1a-1f) at the topside of the metal substrate (2, 22, 32, 42), each of the LEDs (1a-1f) straddling a corresponding one of the insulative portions (3) and being electrically coupled to corresponding ones of the electrode portions (2a-2g);
a support frame (4, 54) at the perimeter of the topside of the metal substrate (2, 22, 32, 42), the support frame (4, 54) comprising an inner wall portion (4b, 54b) and an outer wall portion (4c, 54c) each being integral with the support frame (4, 54), the inner wall portion (4b, 54b) being disposed within the first recessed groove (7), the outer wall portion (4c, 54c) covering an outer perimeter surface (8) of the metal substrate (2, 22, 32, 42) in close contact with the outer perimeter surface (8), and being disposed along an entire perimeter of the metal substrate (2, 22, 32, 42) in close contact with outer lateral surfaces of the metal substrate (2, 22, 32, 42), a backside of the outer wall portion (4c, 54c) being located above the backside of the metal substrate (2, 22, 32, 42), and the support frame (4, 54) being fixedly attached to the perimeter of the topside of the metal substrate (2, 22, 32, 42) via the inner wall portion (4b, 54b) and the outer wall portion (4c, 54c); and
an encapsulation resin (5) disposed within the support frame (4, 54) to at least partially encapsulate the LEDs (1a-1f).

2. The light-emitting device (10, 20, 30, 40, 50, 60) according to claim 1, wherein the LEDs (1a-1f) each comprises a light-emitting surface and the light-emitting surface is either covered by the encapsulation resin (5) or exposed from the encapsulation resin (5).

3. The light-emitting device (30, 40, 50, 60) according to claim 1, further comprising at least one shield wall (33, 53) shielding the plurality of LEDs (1a-1d) at the topside of the metal substrate (32, 42) from each other, the shield wall (33, 53) being parallel to the insulative portions (3) and comprising a leg portion (33c, 53c) within a second recessed groove (34) in the metal substrate (32, 42).

4. The light-emitting device (30, 40, 50, 60) according to claim 3, wherein the second recessed groove (34), within which the leg portion (33c, 53c) of the shield wall (33, 53) is formed, comprises a depth approximately equal to a depth of the first recessed groove (7), which is disposed in the metal substrate (32, 42) and within which the inner wall portion (4b, 54b) of the support frame (4, 54) is formed.

5. The light-emitting device (10, 20, 30, 40, 50, 60) according to claim 1, further comprising at least a pair of external electrodes (6a, 6b) at the backside of the metal substrate (2, 22, 32, 42), one of the external electrodes (6a, 6b) being electrically coupled to the anode of a corresponding one of the electrode portions (2a-2g), and another of the external electrodes (6a, 6b) being electrically coupled to the cathode of a corresponding one of the electrode portions (2a-2g).

6. A method for producing a light-emitting device (10, 20, 30, 40, 50, 60) the method comprising:
forming insulative portions (3) by forming electrode separation grooves (3a) of a predetermined depth in a metal substrate (2, 22, 32, 42) and pouring an insulative resin (3b) into the electrode separation grooves (3a), the metal substrate (2, 22, 32, 42) comprising electrode portions (2a-2g) in a topside of the metal substrate (2, 22, 32, 42);
performing LED mounting by positioning a plurality of LEDs (1a-1f) at the topside of the metal substrate (2, 22, 32, 42) in such a manner that each of the LEDs (1a-1f) straddles a corresponding one of the insulative portions (3) and electrically coupling each of the LEDs (1a-1f) to an anode of a corresponding one of the electrode portions (2a-2g) and to a cathode of a corresponding one of the electrode portions (2a-2g), the electrode portions (2a-2g) being separated from one another by the insulative portions (3);
forming a support frame (4, 54) along a perimeter of the topside of the metal substrate (2, 22, 32, 42), the support frame (4, 54) comprising an inner wall portion (4b, 54b) and an outer wall portion (4c, 54c) each being integral with the support frame (4, 54), the inner wall portion (4b, 54b) being disposed within a first recessed groove (7) formed along the perimeter of the topside of the metal substrate (2, 22, 32, 42), the first recessed groove (7) being shallower than the electrode separation grooves (3a), the outer wall portion (4c, 54c) covering an outer perimeter surface (8) of the metal substrate (2, 22, 32, 42) in close contact with the outer perimeter surface (8), and being disposed along an entire perimeter of the metal substrate (2, 22, 32, 42) in close contact with outer lateral surfaces of the metal substrate (2, 22, 32, 42), the support frame (4, 54) being fixedly attached to the perimeter of the topside of the metal substrate (2, 22, 32, 42) via the inner wall portion (4b, 54b) and the outer wall portion (4c, 54c); and
grinding the metal substrate (2, 22, 32, 42) from a backside of the metal substrate (2, 22, 32, 42) to an extent that the insulative portions (3) are exposed and a bottom of the first recessed groove (7) and a backside of the outer wall portion (4c, 54c) are not ground.

7. The method according to claim 6, further comprising supplying an encapsulation resin (5) to an interior of the support frame (4, 54) to at least partially encapsulate the LEDs.

8. The method according to claim 6, further comprising forming a leg portion (33c, 53c) of a shield wall (33, 53) within a second recessed groove (34), the second recessed groove (34) being formed in the topside of the metal substrate (32, 42) to be parallel to the insulative portions (3), the shield wall (33, 53) shielding the plurality of LEDs (1a-1f) from each other.

9. The method according to claim 6, wherein, in the grinding of the metal substrate (2, 22, 32, 42), the backside of the metal substrate (2, 22, 32, 42) is ground to expose the electrode separation grooves (3a) and the insulative resin of the insulative portions (3) to the backside of the metal substrate (2, 22, 32, 42) without exposing the inner wall portion (4b, 54b) of the support frame (4, 54), the inner wall portion (4b, 54b) being formed within the first recessed groove (7) in the metal substrate (2, 22, 32, 42).

## Patentansprüche

1. Licht emittierende Vorrichtung (10, 20, 30, 40, 50, 60), die aufweist:
ein Metallsubstrat (2, 22, 32, 42) mit Elektrodenabschnitten (2a-2g) auf einer Oberseite des Metallsubstrats (2, 22, 32, 42);
eine erste ausgesparte Nut (7) entlang eines Umfangs der Oberseite des Metallsubstrats (2, 22, 32, 42);
Isolierabschnitte (3), von denen jeder jeweilige Elektrodenabschnitte (2a-2g) der Elektrodenabschnitte (2a-2g) voneinander trennt, so dass einer der Elektrodenabschnitte (2a-2g) als Anode dient und ein anderer der Elektrodenabschnitte (2a-2g) als Kathode dient, wobei die Isolierabschnitte (3) jeweils eine sich durch das Metallsubstrat (2, 22, 32, 42) erstreckende Elektrodentrennnut (3a) und ein isolierendes Harz (3b) aufweisen, das die Elektrodentrennnut (3a) füllt und an einer Rückseite des Metallsubstrats (2, 22, 32, 42) freiliegt;
eine Mehrzahl von LEDs (1a-1f) an der Oberseite des Metallsubstrats (2, 22, 32, 42), wobei jede der LEDs (1a-1f) einen jeweiligen Isolierabschnitt (3) der Isolierabschnitte (3) überspannt und elektrisch mit jeweiligen Elektrodenabschnitten (2a-2g) der Elektrodenabschnitte (2a-2g) gekoppelt ist;
einen Halterahmen (4, 54) am Umfang der Oberseite des Metallsubstrats (2, 22, 32, 42), wobei der Halterahmen (4, 54) einen Innenwandabschnitt (4b, 54b) und einen Außenwandabschnitt (4c, 54c) aufweist, die jeweils einstückig mit dem Halterahmen (4, 54) ausgebildet sind, wobei der Innenwandabschnitt (4b, 54b) in der ersten ausgesparten Nut (7) angeordnet ist, wobei der Außenwandabschnitt (4c, 54c) eine Außenumfangsfläche (8) des Metallsubstrats (2, 22, 32, 42) in engem Kontakt mit der Außenumfangsfläche (8) überdeckt und entlang eines gesamten Umfangs des Metallsubstrats (2, 22, 32, 42) in engem Kontakt mit Außenseitenflächen des Metallsubstrats (2, 22, 32, 42) angeordnet ist, wobei sich eine Rückseite des Außenwandabschnitts (4c, 54c) weiter oben als die Rückseite des Metallsubstrats (2, 22, 32, 42) befindet, und wobei der Halterahmen (4, 54) vermittels des Innenwandabschnitts (4b, 54b) und des Außenwandabschnitts (4c, 54c) fest am Umfang der Oberseite des Metallsubstrats (2, 22, 32, 42) angebracht ist; und
ein Vergussharz (5), das innerhalb des Halterahmens (4, 54) angeordnet ist, um die LEDs (1a-1f) zumindest teilweise einzukapseln.

2. Licht emittierende Vorrichtung (10, 20, 30, 40, 50, 60) nach Anspruch 1, wobei die LEDs (1a-1f) jeweils eine Licht emittierende Fläche aufweisen und die Licht emittierende Fläche entweder durch das Vergussharz (5) bedeckt ist oder aus dem Vergussharz (5) freiliegt.

3. Licht emittierende Vorrichtung (30, 40, 50, 60) nach Anspruch 1, ferner mindestens eine Abschirmwand (33, 53) aufweisend, die die Mehrzahl von LEDs (1a-1d) an der Oberseite des Metallsubstrats (32, 42) voneinander abschirmt, wobei die Abschirmwand (33, 53) parallel zu den Isolierabschnitten (3) verläuft und einen Fußabschnitt (33c, 53c) in einer zweiten ausgesparten Nut (34) in dem Metallsubstrat (32, 42) aufweist.

4. Licht emittierende Vorrichtung (30, 40, 50, 60) nach Anspruch 3, wobei die zweite ausgesparte Nut (34), in welcher sich der Fußabschnitt (33c, 53c) der Abschirmwand (33, 53) befindet, eine Tiefe aufweist, die ungefähr gleich einer Tiefe der ersten ausgesparten Nut (7) ist, die in dem Metallsubstrat (32, 42) angeordnet ist und in der der Innenwandabschnitt (4b, 54b) des Halterahmens (4, 54) angeordnet ist.

5. Licht emittierende Vorrichtung (10, 20, 30, 40, 50, 60) nach Anspruch 1, ferner mindestens ein Paar Außenelektroden (6a, 6b) auf der Rückseite des Metallsubstrats (2, 22, 32, 42) aufweisend, wobei eine der Außenelektroden (6a, 6b) elektrisch mit der Anode eines jeweiligen Elektrodenabschnitts (2a-2g) der Elektrodenabschnitte (2a-2g) gekoppelt ist und eine andere der Außenelektroden (6a, 6b) elektrisch mit der Kathode eines jeweiligen Elektrodenabschnitts (2a-2g) der Elektrodenabschnitte (2a-2g) gekoppelt ist.

6. Verfahren zur Herstellung einer Licht emittierenden Vorrichtung (10, 20, 30, 40, 50, 60), wobei das Verfahren umfasst:
Bilden von Isolierabschnitten (3), indem Elektrodentrennnuten (3a) einer vorbestimmten Tiefe in einem Metallsubstrat (2, 22, 32, 42) gebildet werden und ein isolierendes Harz (3b) in die Elektrodentrennnuten (3a) gegossen wird, wobei das Metallsubstrat (2, 22, 32, 42) Elektrodenabschnitte (2a-2g) auf einer Oberseite des Metallsubstrats (2, 22, 32, 42) aufweist;
Durchführen einer LED-Montage, indem eine Mehrzahl von LEDs (1a-1f) auf der Oberseite des Metallsubstrats (2, 22, 32, 42) derart angeordnet werden, dass jede der LEDs (1a-1f) einen jeweiligen Isolierabschnitt (3) der Isolationsabschnitte (3) überspannt, und indem jede der LEDs (1a-1f) mit einer Anode eines jeweiligen Elektrodenabschnitts (2a-2g) der Elektrodenabschnitte (2a-2g) und mit einer Kathode eines jeweiligen Elektrodenabschnitts (2a-2g) der Elektrodenabschnitte (2a-2g) elektrisch gekoppelt wird, wobei die Elektrodenabschnitte (2a-2g) durch die Isolierabschnitte (3) voneinander getrennt sind;
Ausbilden eines Halterahmens (4, 54) entlang eines Umfangs der Oberseite des Metallsubstrats (2, 22, 32, 42), wobei der Halterahmen (4, 54) einen Innenwandabschnitt (4b, 54b) und einen Außenwandabschnitt (4c, 54c) aufweist, die jeweils einstückig mit dem Halterahmen (4, 54) ausgebildet sind, wobei der Innenwandabschnitt (4b, 54b) in einer entlang des Umfangs der Oberseite des Metallsubstrats (2, 22, 32, 42) ausgebildeten ersten ausgesparten Nut (7) angeordnet ist, wobei die erste ausgesparte Nut (7) weniger tief ist als die Elektrodentrennnuten (3a), wobei der Außenwandabschnitt (4c, 54c) eine Außenumfangsfläche (8) des Metallsubstrats (2, 22, 32, 42) in engem Kontakt mit der Außenumfangsfläche (8) überdeckt und entlang eines gesamten Umfangs des Metallsubstrats (2, 22, 32, 42) in engem Kontakt mit Außenseitenflächen des Metallsubstrats (2, 22, 32, 42) angeordnet ist, wobei der Halterahmen (4, 54) vermittels des Innenwandabschnitts (4b, 54b) und des Außenwandabschnitts (4c, 54c) fest am Umfang der Oberseite des Metallsubstrats (2, 22, 32, 42) angebracht ist; und
Abtragen des Metallsubstrats (2, 22, 32, 42) von einer Rückseite des Metallsubstrats (2, 22, 32, 42) in einem Ausmaß, dass die Isolierabschnitte (3) freigelegt werden und ein Boden der ersten ausgesparten Nut (7) und eine Rückseite des Außenwandabschnitts (4c, 54c) nicht abgetragen werden.

7. Verfahren nach Anspruch 6, ferner umfassend, dass ein Inneres des Halterahmens (4, 54) mit einem Vergussharz (5) versehen wird, um die LEDs zumindest teilweise einzukapseln.

8. Verfahren nach Anspruch 6, ferner umfassend, dass ein Fußabschnitt (33c, 53c) einer Abschirmwand (33, 53) in einer zweiten ausgesparten Nut (34) angeordnet wird, wobei die zweite ausgesparte Nut (34) in der Oberseite des Metallsubstrats (32, 42) derart gebildet ist, dass sie parallel zu den Isolierabschnitten (3) verläuft, wobei die Abschirmwand (33, 53) die Mehrzahl von LEDs (1a-1f) voneinander abschirmt.

9. Verfahren nach Anspruch 6, wobei beim Abtragen des Metallsubstrats (2, 22, 32, 42) die Rückseite des Metallsubstrats (2, 22, 32, 42) abgetragen wird, um die Elektrodentrennnuten (3a) und das isolierende Harz der Isolierabschnitte (3) zur Rückseite des Metallsubstrats (2, 22, 32, 42) freizulegen, ohne den Innenwandabschnitt (4b, 54b) des Halterahmens (4, 54) freizulegen, wobei der Innenwandabschnitt (4b, 54b) in der ersten ausgesparten Nut (7) in dem Metallsubstrat (2, 22, 32, 42) angeordnet ist.

## Revendications

1. Composant électroluminescent (10, 20, 30, 40, 50, 60) comprenant :
un substrat métallique (2, 22, 32, 42) comprenant des parties d'électrode (2a à 2g) sur le côté supérieur du substrat métallique (2, 22, 32, 42),
une première rainure en creux (7) le long du périmètre du côté supérieur du substrat métallique (2, 22, 32, 42),
des parties isolantes (3) séparant chacune l'une de l'autre des parties correspondantes des parties d'électrode (2a à 2g) de sorte à ce que l'une des parties d'électrode (2a à 2g) serve d'anode et une autre des parties d'électrode (2a à 2g) serve de cathode, les parties isolantes (3) comprenant chacune une rainure de séparation d'électrodes (3a) s'étendant au travers du substrat métallique (2, 22, 32, 42) ainsi qu'une résine isolante (3b) remplissant la rainure de séparation d'électrodes (3a) et exposée sur le côté arrière du substrat métallique (2, 22, 32, 42),
une pluralité de diodes LED (1a à 1f) sur le côté supérieur du substrat métallique (2, 22, 32, 42), chacune des diodes LED (1a à 1f) chevauchant l'une correspondante des parties isolantes (3) et étant couplée électriquement aux parties correspondantes des parties d'électrode (2a à 2g),
un cadre de support (4, 54) au niveau du périmètre du côté supérieur du substrat métallique (2, 22, 32, 42), le cadre de support (4, 54) comprenant une paroi interne (4b, 54b) et une paroi externe (4c, 54c) intégrées chacune au cadre de support (4, 54), la paroi interne (4b, 54b) étant placée à l'intérieur de la première rainure en creux (7), la paroi externe (4c, 54c) recouvrant la surface périmétrique externe (8) du substrat métallique (2, 22, 32, 42) en contact intime avec la surface périmétrique externe (8) et étant placée sur tout le long du périmètre du substrat métallique (2, 22, 32, 42) en contact intime avec les surfaces latérales externes du substrat métallique (2, 22, 32, 42), le côté arrière de la paroi externe (4c, 54c) étant situé au-dessus du côté arrière du substrat métallique (2, 22, 32, 42) et le cadre de support (4, 54) étant fixé solidement au périmètre du côté supérieur du substrat métallique (2, 22, 32, 42) par l'intermédiaire de la paroi interne (4b, 54b) et de la paroi externe (4c, 54c), et
une résine d'enrobage (5) placée à l'intérieur du cadre de support (4, 54) pour encapsuler au moins partiellement les diodes LED (1a à 1f).

2. Composant électroluminescent (10, 20, 30, 40, 50, 60) selon la revendication 1, dans lequel les diodes LED (1a à 1f) comprennent chacune une surface électroluminescente, et la surface électroluminescente est soit recouverte par la résine d'enrobage (5), soit exposée à partir de la résine d'enrobage (5).

3. Composant électroluminescent (10, 20, 30, 40, 50, 60) selon la revendication 1, comprenant en outre au moins une paroi de protection (33, 53) protégeant l'une de l'autre la pluralité de diodes LED (1a à 1f) sur le côté supérieur du substrat métallique (32, 42), la paroi de protection (33, 53) étant parallèle aux parties isolantes (3) et comprenant une partie formant montant (33c, 53c) dans une seconde rainure en creux (34) dans le substrat métallique (32, 42).

4. Composant électroluminescent (10, 20, 30, 40, 50, 60) selon la revendication 3, dans lequel la seconde rainure en creux (34) dans laquelle est formée la partie formant montant (33c, 53c) de la paroi de protection (33, 53) présente une profondeur approximativement égale à la profondeur de la première rainure en creux (7) qui est placée dans le substrat métallique (32, 42) et dans laquelle est formée la paroi interne (4b, 54b) du cadre de support (4, 54).

5. Composant électroluminescent (10, 20, 30, 40, 50, 60) selon la revendication 1, comprenant en outre au moins une paire d'électrodes externes (6a, 6b) sur le côté arrière du substrat métallique (2, 22, 32, 42), l'une des électrodes externes (6a, 6b) étant couplée électriquement à l'anode de l'une correspondante des parties d'électrode (2a à 2g), et une autre des électrodes externes (6a, 6b) étant couplée électriquement à la cathode de l'une correspondante des parties d'électrode (2a à 2g).

6. Procédé de fabrication d'un composant électroluminescent (10, 20, 30, 40, 50, 60), le procédé comprenant :
la formation de parties isolantes (3) en formant des rainures de séparation d'électrodes (3a) d'une profondeur prédéterminée dans un substrat métallique (2, 22, 32, 42) et en versant une résine isolante (3b) dans les rainures de séparation d'électrodes (3a), le substrat métallique (2, 22, 32, 42) comprenant des parties d'électrode (2a à 2g) sur le côté supérieur du substrat métallique (2, 22, 32, 42),
la réalisation du montage des diodes LED en positionnant une pluralité de diodes LED (1a à 1f) au niveau du côté supérieur du substrat métallique (2, 22, 32, 42) de manière à ce que chacune des diodes LED (1a à 1f) chevauche l'une correspondante des parties isolantes (3), et en couplant électriquement chacune des diodes LED (1a à 1f) à une anode de l'une correspondante des parties d'électrode (2a à 2g) et à une cathode de l'une correspondante des parties d'électrode (2a à 2g), les parties d'électrode (2a à 2g) étant séparées l'une de l'autre par les parties isolantes (3),
la formation d'un cadre de support (4, 54) le long du périmètre du côté supérieur du substrat métallique (2, 22, 32, 42), le cadre de support (4, 54) comprenant une paroi interne (4b, 54b) et une paroi externe (4c, 54c), chacune étant intégrée au cadre de support (4, 54), la paroi interne (4b, 54b) étant placée à l'intérieur d'une première rainure en creux (7) formée le long du périmètre du côté supérieur du substrat métallique (2, 22, 32, 42), la première rainure en creux (7) étant moins profonde que les rainures de séparation d'électrodes (3a), la paroi externe (4c, 54c) recouvrant la surface périmétrique externe (8) du substrat métallique (2, 22, 32, 42) en contact intime avec la surface périmétrique externe (8) et étant placée le long de tout le périmètre du substrat métallique (2, 22, 32, 42) en contact intime avec les surfaces latérales externes du substrat métallique (2, 22, 32, 42), le cadre de support (4, 54) étant fixé solidement au périmètre du côté supérieur du substrat métallique (2, 22, 32, 42) par l'intermédiaire de la paroi interne (4b, 54b) et de la paroi externe (4c, 54c), et
le meulage du substrat métallique (2, 22, 32, 42) depuis le côté arrière du substrat métallique (2, 22, 32, 42) jusqu'à ce que les parties isolantes (3) soit exposées, et le fond de la première rainure en creux (7) et le côté arrière de la paroi externe (4c, 54c) ne sont pas meulés.

7. Procédé selon la revendication 6, comprenant en outre la fourniture d'une résine d'enrobage (5) sur la partie intérieure du cadre de support (4, 54) pour encapsuler au moins partiellement les diodes LED.

8. Procédé selon la revendication 6, comprenant en outre la formation d'une partie formant montant (33c, 53c) appartenant à une paroi de protection (33, 53) à l'intérieur d'une seconde rainure en creux (34), la seconde rainure en creux (34) étant formée dans le côté supérieur du substrat métallique (32, 42) pour être parallèle aux parties isolantes (3), la paroi de protection (33, 53) protégeant l'une de l'autre la pluralité de diodes LED (1a à 1f).

9. Procédé selon la revendication 6, dans lequel, lors du meulage du substrat métallique (2, 22, 32, 42), le côté arrière du substrat métallique (2, 22, 32, 42) est meulé pour exposer les rainures de séparation d'électrodes (3a) et la résine isolante des parties isolantes (3) au côté arrière du substrat métallique (2, 22, 32, 42) sans exposer la paroi interne (4b, 54b) du cadre de support (4, 54), la paroi interne (4b, 54b) étant formée à l'intérieur de la première rainure en creux (7) dans le substrat métallique (2, 22, 32, 42).
